# EUROPEAN PATENT SPECIFICATION

(11) **EP 4 243 385 B1**
(45) Date of publication and mention of the grant of the patent: **28.01.2026**
(21) Application number: 22214150.9
(22) Date of filing: 16.12.2022
(51) Int. Cl.: H04M 1/02, G06F 1/16

(54) **ELECTRONIC DEVICE INCLUDING A PLURALITY OF FLEXIBLE PRINTED CIRCUIT BOARDS**
ELEKTRONISCHE VORRICHTUNG MIT MEHREREN FLEXIBLEN LEITERPLATTEN
DISPOSITIF ÉLECTRONIQUE COMPRENANT UNE PLURALITÉ DE CARTES DE CIRCUIT IMPRIMÉ FLEXIBLES

(30) Priority: 11.03.2022 KR 20220030773; 01.07.2022 KR 20220081260; 16.11.2022 WO PCT/KR2022/018123
(43) Date of publication of application: 13.09.2023
(73) Proprietor: Samsung Electronics Co., Ltd., Gyeonggi-do 16677 (KR)
(72) Inventor: Lee, Wonho, 16677 Suwon-si, Gyeonggi-do (KR); Kim, Hyunsuk, 16677 Suwon-si, Gyeonggi-do (KR); Park, Sanghyuk, 16677 Suwon-si, Gyeonggi-do (KR); Seo, Soohyun, 16677 Suwon-si, Gyeonggi-do (KR); Cho, Joongyeon, 16677 Suwon-si, Gyeonggi-do (KR); Choi, Nakhyun, 16677 Suwon-si, Gyeonggi-do (KR); Lee, Junghyeob, 16677 Suwon-si, Gyeonggi-do (KR); Hong, Hyunju, 16677 Suwon-si, Gyeonggi-do (KR)
(74) Representative: Gulde & Partner

(56) References cited:
- WO-A1-2022/050762
- US-A1- 2020 267 839
- US-A1- 2022 035 410
- US-A1- 2023 208 013

## Description

### [Technical Field]

Embodiments to be described later relate to an electronic device including a plurality of flexible printed circuit boards.

### [Background Art]

In order to achieve portability and usability of an electronic device, a flexible display that may provide a large screen display when necessary is being developed. The flexible display may be foldably, rollably or slidably disposed within the electronic device. WO 2022/050762 A1 discloses an electronic device including a first housing, a second housing configured to slide from the first housing, a flexible display disposed to the first housing and the second housing and having a screen configured to be reduced/extended according to the sliding of the second housing. US 2020/0267839 A1 discloses a foldable electronic device including: a housing; a first printed circuit board disposed in the housing; a second printed circuit board disposed in the housing and spaced apart from the first printed circuit board; a first flexible printed circuit board electrically connecting the first printed circuit board and the second printed circuit board; and a second flexible printed circuit board electrically connecting the first printed circuit board and the second printed circuit board, in which the second flexible printed circuit board is longer than the first flexible printed circuit board.

### [Disclosure]

### [Technical Problem]

An electronic device including a slidable display may comprise one support member and another support member. The other support member slides-in the one support member or slides-out from the one support member. Depending on the state of the electronic device, a gap between the support members may vary. There is a need for a method for preventing damage due to deformation of a flexible printed circuit board or a flexible cable that is connected to printed circuit boards disposed in the support members. The electronic device may provide a structure capable of preventing a flexible printed circuit board and preventing interference of a signal transmitted through the flexible printed circuit board.

The technical problems to be achieved in this document are not limited to those described above, and other technical problems not mentioned herein will be clearly understood by those having ordinary knowledge in the art to which the present disclosure belongs, from the following description.

### [Technical Solution]

According to an embodiment, an electronic device is provided as defined in the appended claims.

### [Advantageous Effects]

According to an embodiment, an electronic device including a plurality of flexible printed circuit boards can prevent damage due to deformation of the flexible printed circuit board based on a change in the state of the electronic device by providing a foldable structure of the flexible printed circuit board.

According to an embodiment, an electronic device including a plurality of flexible printed circuit boards can provide a flexible printed circuit board configured to shield an external signal.

The effects that can be obtained from the present disclosure are not limited to those described above, and any other effects not mentioned herein will be clearly understood by those having ordinary knowledge in the art to which the present disclosure belongs, from the following description. Since many features (except those of the independent claims) are optional only, the features of the preferred embodiments have been described in connection with "may". Nevertheless, said preferred embodiments have to understood to be disclosed as specific preferred combinations as shown in the drawings and therefore features shown in the drawings are to be understood as a real preferred combination for the present invention which however does not restrict the scope of the invention.

### [Description of the Drawings]

FIG. 1 is a block diagram of an electronic device in a network environment according to an embodiment.
FIG. 2A is a front view of a first state of an electronic device according to an embodiment.
FIG. 2B is a rear view of a first state of an electronic device according to an embodiment.
FIG. 3A is a front view of a second state of an electronic device according to an embodiment.
FIG. 3B is a rear view of the second state of the electronic device according to an embodiment.
FIG. 4 is an exploded perspective view of an electronic device according to an embodiment.
FIG. 5 shows an inside of an electronic device in a first state.
FIG. 6 shows an inside of the electronic device in a second state.
FIG. 7 shows a cross-sectional view of an electronic device in a first state.
FIG. 8 shows a cross-sectional view of an electronic device in a second state.
FIG. 9 shows a disposition of the flexible printed circuit board in a first state.
FIG. 10 shows a disposition of the flexible printed circuit board in a second state.
FIG. 11 is a cross-sectional view that the flexible printed circuit board and the third printed circuit board of FIG. 9.
FIG. 12A shows a shape of a flexible printed circuit board in a first state.
FIG. 12B shows a deformed shape of a flexible printed circuit board in a second state.
FIG. 13 schematically shows a configuration of a flexible printed circuit board.

### [Mode for Invention]

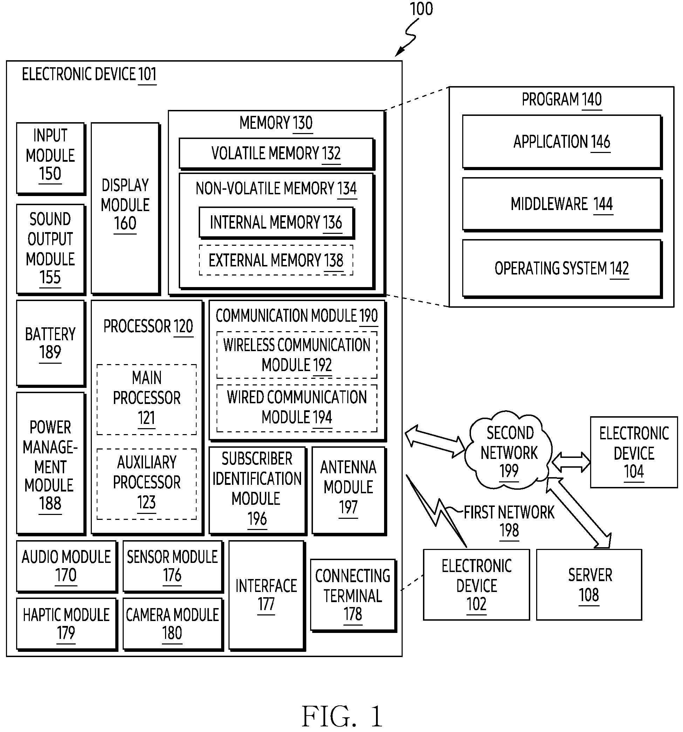

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

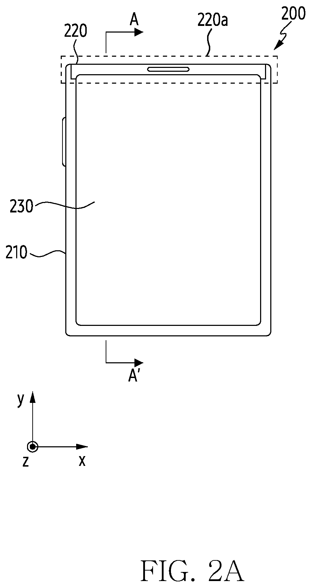

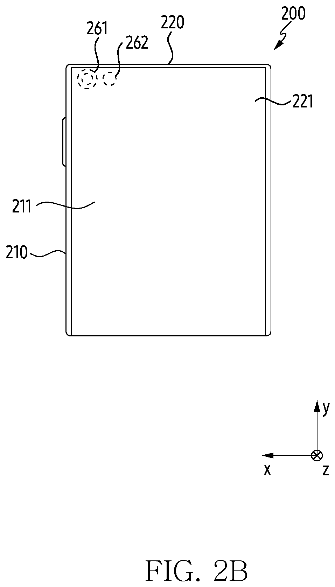

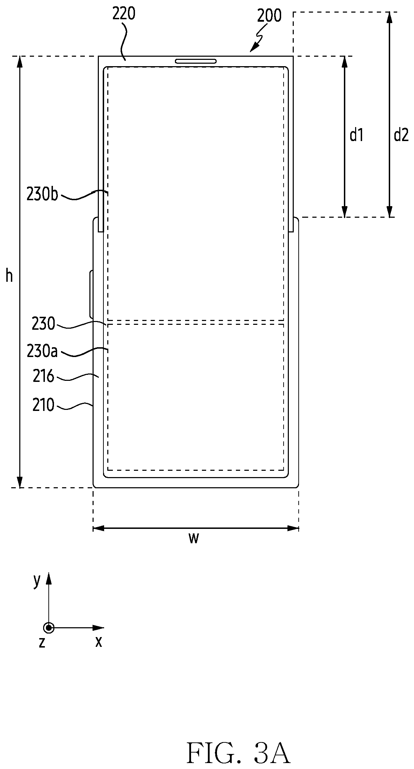

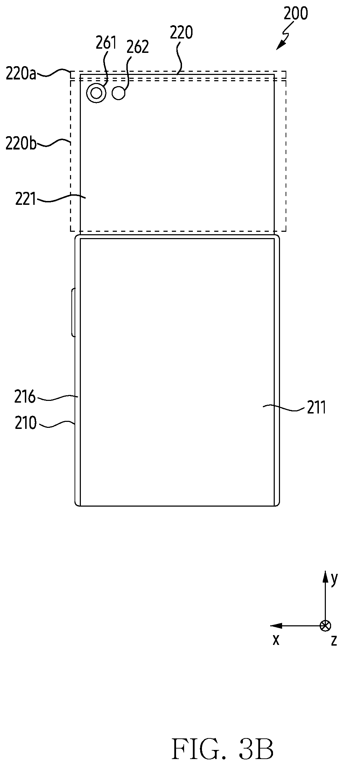

FIG. 2A is a front view of a first state of an electronic device according to an embodiment. FIG. 2B is a rear view of a first state of an electronic device according to an embodiment. FIG. 3A is a front view of a second state of an electronic device according to an embodiment. FIG. 3B is a rear view of the second state of the electronic device according to an embodiment.

Referring to FIGS. 2A, 2B, 3A, and 3B, an electronic device 200 (e.g., the electronic device 101 of FIG. 1) according to an embodiment may comprise a first housing 210 and a second housing 220. According to an embodiment, the second housing 220 may move in a designated direction from the first housing 210, for example, in a first direction (+y direction). For example, the second housing 220 may slide by a distance designated in the first direction (+y direction) from the first housing 210. According to an embodiment, the second housing 220 may reciprocate in a scope of within designated distance in the first direction (+y direction) from a portion of the first housing 210.

In an embodiment, a state in which the second housing 220 slide moves in a direction in which the first housing 210 faces, for example, in a second direction (-y direction) opposite to the first direction (+y direction), may be defined as a first state (e.g., a contracted state or a slide-in state) of the electronic device 200. In an embodiment, the first state of the electronic device 200 may be defined as a state in which a second portion 230b of the display 230 is not visually exposed from the outside. The first state of the electronic device 200 may refer to a state in which the second portion 230b of the display 230 is located inside the second housing 220.

In an embodiment, a state in which the second housing 220 slide moves from the first housing 210 in the first direction (+y direction) may be defined as a second state (e.g., an expanded state or a slide-out state) of the electronic device 200. In an embodiment, the second state of the electronic device 200 may be defined as a state in which the second portion 230b of the display 230 is visually exposed from the outside. The second state of the electronic device 200 may refer to a state in which the second portion 230b of the display 230 is located outside the second housing 220. According to an embodiment, the second housing 220 may move from the first housing 210 in the first direction (+y direction), so that at least a portion of the second housing 220 and/or the second portion 230b of the display 230 may slide-out from the first housing 210, and a sliding length d1 may correspond to a moving distance. According to an embodiment, the second housing 220 may reciprocate within a designated distance d2. According to an embodiment, the sliding length d1 may have a length in a range from about 0 to a designated-length d2.

In an embodiment, a first state may be referred to as a first shape, and a second state may be referred to as a second shape. For example, the first shape may comprise a normal state, a contracted state, or a closed state, and the second shape may comprise an open state. In addition, in an embodiment, an electronic device 400 may form a third state (e.g., an intermediate state) that is a state between the first state and the second state. For example, the third state may be referred to as a third shape, and the third shape may comprise a free stop state. For example, in the first state, a ratio of a height h to a width w may be 4.5 to 3. With a movement of the second housing 220, in the second state, the ratio of the height h to the width w may be 21 to 9. In the third state, which is an intermediate state between the first state and the second state, the ratio of the height h to the width w may be 16 to 9.

In interconverting to the second state and/or the first state, the electronic device 200 according to an embodiment may be manually converted by a user's operation or may be automatically converted through a driving module (not illustrated) disposed inside the first housing 210 or the second housing 220. According to an embodiment, the driving module may trigger an operation based on a user input. According to an embodiment, the user input for triggering the operation of the driving module may comprise a touch input, a force touch input, and/or a gesture input through the display 230. In another embodiment, the user input for triggering the operation of the driving module may comprise a sound input (voice input) or an input of a physical button exposed to the outside of the first housing 210 or the second housing 220. According to an embodiment, the driving module may be driven in a semi-automatic manner in which an operation is triggered when a manual operation by a user's external force is detected.

According to one embodiment, the electronic device 200 may be named "slidable electronic device" as the second housing 220 is designed to slide, or it may be named "rollable electronic device" as at least a portion of the display 230 is designed to be wound inside the second housing 220 (or the first housing 210) based on the slide movement of the second housing 220.

According to an embodiment, the second housing 220 may be at least partially slidably-moveable from the first housing 210. According to an embodiment, the coupling form of the first housing 210 and the second housing 220 is not limited to the form and coupling illustrated in FIGS. 2A, 2B, 3A, and 3B, and may be implemented by a combination and/or coupling of other shapes or components.

According to an embodiment, the first housing 210 of the electronic device 200 may comprise a book cover 216 surrounding the inner space of the first housing 210 and a rear plate 211 surrounding the rear surface of the book cover 216. The second housing 220 of the electronic device 200 may comprise a slide cover 221 surrounding the inner space of the second housing 220.

According to an embodiment, the second housing 220 or the slide cover 221 may comprise a first cover region 220a of the second housing 220 that is always visually exposed from the outside in the second state and the first state of the electronic device 200 without slide in the inside of the first housing 210, and a second cover region 220b that slide in or slide out the inner space of the first housing 210. According to an embodiment, the second cover region 220b of the second housing 220 may not be visually exposed from the outside in the first state, but may be visually exposed from the outside in the second state.

According to an embodiment, the display 230 may be disposed to be visually exposed from the outside through the front direction (e.g., +z direction) of each of the first housing 210 and the second housing 220. According to an embodiment, the display area of the display 230 may comprise a first portion 230a and a second portion 230b.

According to an embodiment, the first portion 230a of the display 230 may be a display area that is fixedly visually exposed from the outside regardless of whether the electronic device 200 is in the second state or the first state. For example, the first portion 230a of the display 230 may be fixed without movement regardless of the slide movement of the second housing 220.

According to an embodiment, the second portion 230b of the display 230 may be a display area extending from one end of the first portion 230a, and by interworking with the slide movement of the second housing 220, may slide in the inner space of the second housing 220 or may slide out the inner space of the second housing 220 to the outside. According to an embodiment, a hole (not illustrated) through which the second portion 230b of the display 230 is slid out or slid in may be disposed adjacent to the +y-direction side surface of the second housing 220. For example, the second portion 230b of the display 230 may be slid out or slid in from a boundary portion of +y direction of the second housing 220.

According to an embodiment, in the second state, the second portion 230b of the display 230 may be slid out the outside from the inner space of the second housing 220 and visually exposed from the outside. According to an embodiment, in the first state, the second portion 230b of the display 230 may be slid in the inner space of the second housing 220 and may not be visually exposed from the outside.

According to an embodiment, the display 230 may comprise a flexible display. The second portion 230b of the display 230 may be folded while being rolled into the inner space of the second housing 220 in the first state.

According to an embodiment, only the first portion 230a of the display area of the display 230 within the first state, may be visually exposed from the outside. The second portion 230b of the display area of the display 230 within the second state, may be visually exposed from the outside.

According to an embodiment, the electronic device 200 may comprise a camera module 261 and/or a flash 262. In the first state, the camera module 261 and/or the flash 262 may be covered by the rear plate 211 of the first housing 210. In the second state, the camera module 261 and/or the flash 262 may be exposed to the outside through an opening formed in the slide cover 221. However, it is not limited thereto, and by forming an opening or notch on the rear plate 211, in the first state, the electronic device 200 may provide a structure in which the camera module 261 and/or the flash 262 are exposed to the outside. Although the camera module 261 is illustrated as including one camera, the camera module 261 may comprise a plurality of cameras. For example, the camera module 261 may comprise a wide-angle camera, an ultra-wide-angle camera, a telephoto camera, a proximity camera, and/or a depth camera. According to an embodiment, the camera module 261 may comprise one or a plurality of lenses, an image sensor, and/or an image signal processor. According to an embodiment, the flash 262 may comprise, for example, a light emitting diode or a xenon lamp.

According to an embodiment, the electronic device 200 may comprise a sensor module (not illustrated) and/or a camera module (not illustrated) disposed under the display 230 (e.g., -z direction from the display 230). The sensor module may detect an external environment based on information (e.g., light) received through the display 230. According to an embodiment, the sensor module may comprise at least one of a receiver, a proximity sensor, an ultrasonic sensor, a gesture sensor, a gyro sensor, an air pressure sensor, a magnetic sensor, an acceleration sensor, a grip sensor, a color sensor, an IR (infrared) sensor, a biometric sensor, a temperature sensor, a humidity sensor, a motor encoder, or an indicator. According to an embodiment, at least some sensor modules of the electronic device 200 may be visually exposed from the outside through a partial region of the display 230. According to an embodiment, the electronic device 200 may detect a sliding length (e.g., length A) using a sensor module. According to an embodiment, the electronic device 200 may generate slide-out information on the slide-out degree sensed by the sensor. For example, the electronic device 200 may detect and/or identify the slide-out degree of the second housing 220 using the slide-out information. According to an embodiment, the slide-out information may comprise information on a sliding length of the second housing 220.

The electronic device 200 according to an embodiment may comprise housings (e.g., the first housing 210 and the second housing 220), and a display 230 supported by the housings 210 and 220, and adjusted the region of the display area in conjunction with at least a portion of the housings 210 and 220 moving in the first direction (+y direction). The display area of the display 230 may comprise a first portion 230a that is fixedly exposed to the outside regardless of at least a portion of the second housing 220 moving in the first direction (+y direction), and a second portion 230b extending from one end of the first portion 230a and exposed to the outside by being slid out from the inner space of the first housing 210 in conjunction with at least a portion of the second housing 220 moving in the first direction (+y direction).

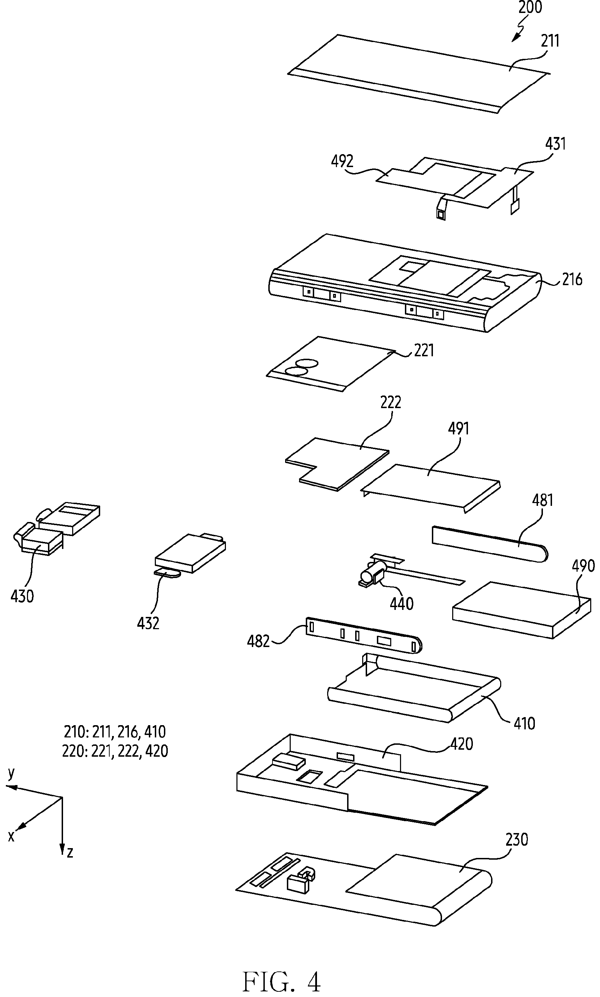

FIG. 4 is an exploded perspective view of an electronic device according to an embodiment.

Referring to FIG. 4, an electronic device 200 may comprise a first housing 210, a second housing 220, and a display 230.

In an embodiment, the first housing 210 may comprise a rear plate 211, a book cover 216, and/or a first support member 410. The book cover 216 may form a portion of an exterior of the electronic device 200, and the rear plate 211 may form a portion of a rear surface of the electronic device 200. The rear plate 211 may be disposed in a direction (e.g., -z direction) facing one surface of the book cover 216. The book cover 216 may form a side surface of the electronic device 200, and may provide a surface on which the rear plate 211 is to be seated.

According to an embodiment, the first support member 410 may be disposed inside from the book cover 216. For example, the first support member 410 may be surrounded by the book cover 216. The first support member 410 may be disposed between the display 230 and the book cover 216. For example, the book cover 216 may surround a space between the rear plate 211 and the first portion 230a of the display 230. The first support member 410 may extend from the book cover 216 in the space.

According to an embodiment, the first support member 410 may support or accommodate other components comprised in the electronic device 200. For example, the first portion 230a of the display 230 may be disposed on one surface of the first support member 410 facing one direction (e.g., +z direction), and the first portion 230a of the display 230 may be supported by the first support member 410. For another example, a first printed circuit board 431 and an actuator assembly 440 may be disposed on the other surface facing the direction (e.g., -z direction) opposite to the one direction of the first support member 410. The first printed circuit board 431 and the actuator assembly 440 may be seated in holes defined by the recess or the rear plate 211 defined by the first support member 410 and the book cover 216, respectively. For example, the first printed circuit board 431 may be disposed in a space formed between the book cover 216 and the first support member 410. A wireless charging module 492 may be disposed on the outer surface of the book cover 216. For example, the wireless charging module 492 may be disposed between the book cover 216 and the rear plate 211. The wireless charging module 492 may be connected to the first printed circuit board 431. The first printed circuit board 431 may electrically connect the wireless charging module 492 and the battery 490. The first printed circuit board 431 may further comprise a power management module that distributes power between the wireless charging module 492 and the battery 490. Although the first printed circuit board 431 has been described as one printed circuit board, it is not limited thereto, and may be configured of a plurality of printed circuit boards.

According to an embodiment, the first printed circuit board 431 and the actuator assembly 440 may be respectively coupled to the first support member 410. For example, a second printed circuit board 432 may be fixed to the first support member 410 through a coupling member such as a screw. The actuator (e.g., a motor) of the actuator assembly 440 may be fixed to the first support member 410 through a coupling member. However, the fixing method or coupling method is not limited to the above-described method.

According to an embodiment, the book cover 216 may be disposed between the first support member 410 and the rear plate 211. According to an embodiment, the book cover 216 may be disposed on the first support member 410. For example, the book cover 216 may be disposed on a surface facing the -z direction of the first support member 410.

According to an embodiment, the book cover 416 may at least partially overlap the first printed circuit board 431 when viewed in a z-axis direction. The book cover 416 may cover at least a partial region of the first printed circuit board 431. The book cover 416 may protect the first printed circuit board 431 from physical impact. The book cover 416 may be coupled to the first support member 410 through a coupling member (e.g., a screw). The first support member 410 may comprise a sidewall capable of accommodating the battery 490. For example, the first support member 410 may comprise a seating portion formed by a sidewall, and the battery 490 may be accommodated in the seating portion. The battery cover 491 may surround the battery 490, and together with the sidewall of the first support member 410 may form a space in which the battery 490 is to be seated.

According to an embodiment, the second housing 220 may comprise a slide cover 221, a slide plate 222, and/or a second support member 420. The slide cover 221 may form another portion of the exterior of the electronic device 200. For example, the book cover 216 may form a portion of the exterior of the electronic device 200, and the slide cover 221 may form a portion of the other exterior of the electronic device 200. According to an embodiment, the second housing 220 may be slidably coupled to the first housing 210. For example, in the first state, the second cover region 220b of the second housing 220 may be in the first housing 210. In the second state, the first cover region 210b of the second housing 220 may move along the first direction (+y direction) to be exposed to the outside of the first housing 210. The electronic device 101 may comprise guide members 481 and 482 to prevent the second housing 220 from being tilted with respect to the first housing 210 due to the movement of the second housing 220. The guide members 481 and 482 may guide the movement of the second housing 220 and may support the second housing 220. The guide members 481 and 482 may prevent the second housing 220 from being tilted in the -z-axis direction with respect to the first housing 210 when the second housing 220 is slid out. The guide members 481 and 482 may prevent the second housing 220 from being tilted in the -z-axis direction with respect to the first housing 210 when the second housing 220 is slid out.

According to an embodiment, the slide plate 222 may be disposed between the slide cover 221 and the second support member 420. In the second support member 420, an electronic component 430 and the second printed circuit board 432 may be disposed. The electronic component 430 may comprise a camera module and the like. The slide plate 222 and the slide cover 221 may provide a structure (e.g., opening) for exposing a camera module or a sensor to the outside.

According to an embodiment, when the display 230 is extended to the second state, the support bar (not illustrated) may support the second portion 230b of the display 230. For example, the support bar may be formed in a shape corresponding to the shape of the second portion 230b of the display 230 by combining a plurality of bars. According to an embodiment, in the first state in which the second portion 230b of the display 230 is wound in the second housing 220, the support bar may be wound in the second housing 220 together with the second portion 230b of the display 230. The support bar may move along a guide rail formed on the inner surface of the slide cover 221. As the support bar 226 moves inside the slide cover 221, the second portion 230b of the display 230 may be wound inside the slide cover 221.

According to an embodiment, the second portion 230b of the display 230 may be slid out from the inner space of the second housing 220 to the outside in the second state. For example, as the support bar 226 moves from the inner space of the slide cover 221 to the outside along the guide rail formed on the inner surface of the slide cover 221, the second portion 230b of the display 230 may be slid out from the inner space of the slide cover 221 to the outside.

According to an embodiment, the second support member 420 may extend inward from the slide cover 221. For example, the second support member 420 may be surrounded by the slide cover 221 and the second portion 230b of the display 230. The second support member 420 may move in the first direction (+y direction) when the display 230 is expanded. For example, in the first state, the second support member 420 may be disposed under the first portion 230a of the display 230 or the first support member 410 (e.g., -z direction with respect to the display 230). In the second state, the second support member 420 may move in the first direction (+y direction) and be disposed under the second portion 230b of the display 230. The second support member 420 may surround a space between the slide cover 221 and the display 230. The second support member 420 may extend from the slide cover 221 within the space.

According to an embodiment, the second support member 420 may support or accommodate other components comprised in the electronic device 200. For example, the second support member 420 may support the support bar 226. The support bar 226 may be supported by the second support member 420 while moving along the inner surface of the slide cover 221 and may maintain the shape of the second portion 230b of the display 230. The camera module 261 and the flash 262 may be disposed on the second support member 420. The camera module 261 and the flash 262 may be respectively seated in a recess defined by the second support member 420 or a hole defined by the slide cover 221. The second support member 420 may be coupled to an actuator of the actuator assembly 440 or a case 470 surrounding the actuator. For example, the case 470 or the actuator may be fixed to the second support member 420 through a coupling member such as a screw. However, the fixing method or coupling method is not limited to the above-described method.

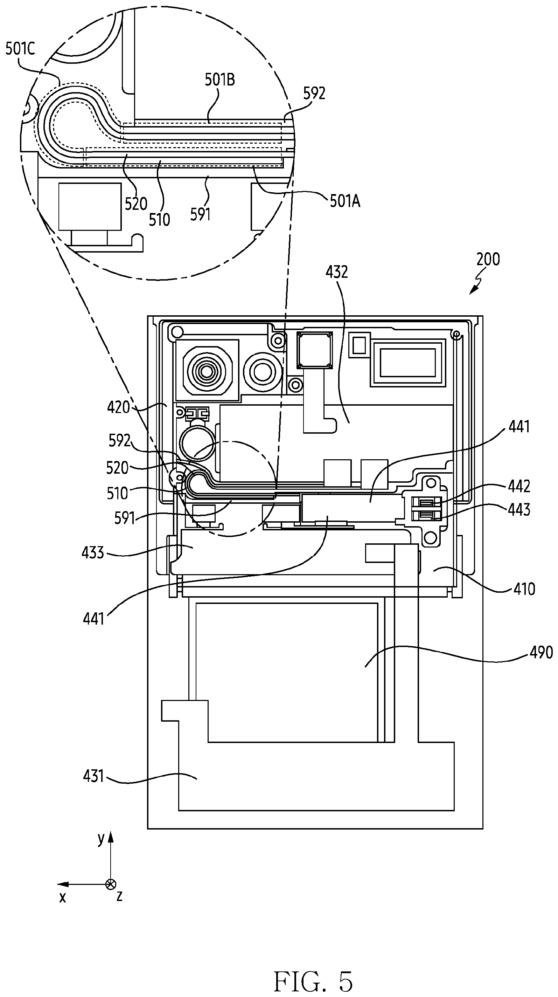

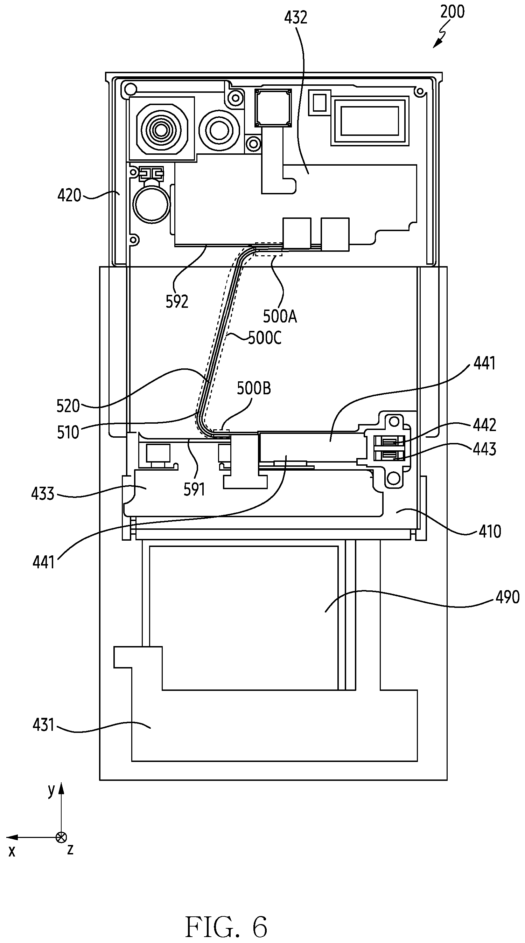

FIG. 5 shows an inside of an electronic device in a first state. FIG. 6 shows an inside of the electronic device in a second state.

Referring to FIGS. 5 and 6, the electronic device 200 may comprise a first support member 410, a second support member 420, a display 230, a first printed circuit board 431, a second printed circuit board 432, a third printed circuit board 433, a first flexible printed circuit board 510, and a second flexible printed circuit board 520.

According to an embodiment, the first support member 410 may support the first printed circuit board 431 and the third printed circuit board 433. The first printed circuit board 431 may be disposed at a lower portion (-y direction) of the first support member 410. For example, the first printed circuit board 431 may be disposed at a periphery far from the second support member 420 among peripheries of the first support member 410. The third printed circuit board 433 may be disposed on the upper portion (+y direction) of the first support member 410. The third printed circuit board 433 may be disposed at a periphery close to the second support member 420 among peripheries of the first support member 410.

According to an embodiment, the first support member 410 may support the battery 490. The first support member 410 may form a seating portion capable of accommodating the battery 490 and may comprise a first sidewall 591 formed along the seating portion of the battery. The battery 490 may be accommodated in a seating portion formed by the first sidewall 591 of the first support member 410. The battery 490 may be disposed between the first printed circuit board 431 and the third printed circuit board 433. According to an embodiment, a portion of the battery 490 may overlap the first printed circuit board 431 and the third printed circuit board 433. For example, a portion of the first printed circuit board 431 may be overlapped the lower portion (-y direction) of the battery 490, and a portion of the third printed circuit board 433 may be overlapped the upper portion (+y direction) of the battery 490.

According to an embodiment, the first printed circuit board 431 and the third printed circuit board 433 may be connected to each other by a separate board or cable. According to an embodiment, the first printed circuit board 431 may be electrically connected to some of the electrical objects disposed on the first support member 410. The first printed circuit board 431 may be electrically connected to an electrical object adjacent to the first printed circuit board (e.g., located under the first support member 410). The first printed circuit board 431 may be electrically connected to an antenna module, a speaker module, or an interface disposed on the first support member 410.

According to an embodiment, the second printed circuit board 432 may be electrically connected to an electrical object disposed on the second support member 420. For example, the second printed circuit board 432 may be electrically connected to a camera module or at least one processor.

According to an embodiment, the second printed circuit board 432 may be electrically connected to the first printed circuit board 431. The second printed circuit board 432 and the first printed circuit board 431 may be electrically connected through at least one flexible printed circuit board 500 and/or the third printed circuit board 433.

According to an embodiment, the second printed circuit board 432 may be connected to the first flexible printed circuit board 510 and/or the second flexible printed circuit board 520. Each of the first flexible printed circuit board 510 and the second flexible printed circuit board 520 may comprise a connector. The second printed circuit board 432 may be coupled to the connector of the first flexible printed circuit board 510 and/or the connector of the second flexible printed circuit board 520. The third printed circuit board 433 may be connected to the first flexible printed circuit board 510 and/or the second flexible printed circuit board 520. The first flexible printed circuit board 510 and/or the second flexible printed circuit board 520 may be coupled to the third printed circuit board 433 through connectors different from the connectors.

According to an embodiment, the third printed circuit board 433 may be disposed between the first printed circuit board 431 and the second printed circuit board 432. The third printed circuit board 433 may connect the first printed circuit board 431 and the second printed circuit board 432 to each other. According to an embodiment, the first flexible printed circuit board 510 may be connected to the third printed circuit board 433 to transmit data and/or control signals transmitted from the first printed circuit board 431 to the second printed circuit board 432. According to an embodiment, the first flexible printed circuit board 510 may be electrically connected to the battery 490 disposed or connected to the third printed circuit board 433 and the actuator 441 of the actuator assembly (e.g., the actuator assembly 440 of FIG. 4). The first flexible printed circuit board 510 may transfer power from the battery 490 to the second printed circuit board 432. The transmitted power may be mounted on the second printed circuit board 432 or supplied to connected components. For example, the power transmitted from the battery 490 may be supplied to the electronic component 430 such as at least one processor or a camera module disposed on the second printed circuit board 432. According to an embodiment, the actuator 441 of the actuator assembly 440 connected to the third printed circuit board 433 may receive data and/or signals from at least one processor disposed on the second printed circuit board 432 through the first flexible printed circuit board 510. According to an embodiment, the third printed circuit board 433 may be electrically connected to a wireless charging module (e.g., the wireless charging module 492 of FIG. 4). The third printed circuit board 433 may supply power received from the wireless charging module 492 to the battery 490. According to an embodiment, the actuator 441 disposed in the first support member 410 may rotate the pinion gear 442 coupled to the rotation shaft of the actuator 441. The pinion gear 442 may move the rack gear 443 engaged with the gear teeth of the pinion gear 442. For example, the actuator 441 may linearly move the rack gear 443 by rotating the pinion gear 442. The rack gear 443 coupled to the second support member 420 may move the second support member 420 in the first direction (+y direction) or the second direction (-y direction) by the actuator 441.

According to an embodiment, the second flexible printed circuit board 520 may be connected to the third printed circuit board 433 to transmit a wireless communication signal to the first printed circuit board 431 connected to the antenna module, or to transmit a wireless communication signal from the first printed circuit board 431 to the third printed circuit board 433. The second flexible printed circuit board 520 transmits a high-frequency wireless communication signal, and may be greatly affected by a surrounding electromagnetic field, so a shielding structure for blocking this may be required. For example, the first flexible printed circuit board 510 and the second flexible printed circuit board 520 adjacent to the first flexible printed circuit board 510 may comprise a shielding member to reduce signal interference between each other. For example, the first flexible printed circuit board 510 and the second flexible printed circuit board 520 may each comprise EMI film or comprise copper foil surrounding a portion of the transmission line.

According to the invention, the first flexible printed circuit board 510 comprises a first rigid region fixed by the first support member 410, a second rigid region fixed by the second support member 420, and a first flexible region deformed by the movement of the second support member 420. The second flexible printed circuit board 520 comprises a third rigid region corresponding to the first rigid region, a fourth rigid region corresponding to the second rigid region, and a second flexible region corresponding to the first flexible region. Using flexible printed circuit boards can prevent damage due to deformation of the flexible printed circuit board based on a change in the state of the electronic device by providing a foldable structure of the flexible printed circuit board.

Referring to FIG. 6, the first rigid region and the third rigid region located in the region 500B may be fixed by the first sidewall 591 of the first support member 410. The first sidewall 591 may further comprise a slit (not illustrated) for fixing the first rigid region and the third rigid region. For example, the first flexible printed circuit board 510 and the second flexible printed circuit board 520 may be fixed by being inserted into a structure such as a slit formed in the first sidewall 591.

The first rigid region may be a portion of the first flexible printed circuit board 510 located in the region 500B, and the third rigid region may be a portion of the second flexible printed circuit board 520 located in the region 500B. The second rigid region and the fourth rigid region located in the region 500A may be fixed by the second sidewall 592 of the second support member 420. The second rigid region may be a portion of the first flexible printed circuit board 510 located in the region 500A, and the fourth rigid region may be a portion of the second flexible printed circuit board located in the region 500A. According to an embodiment, the first flexible printed circuit board 510 may extend from the first rigid region in the region 500B or may be connected to the third printed circuit board 433 through a connector formed in the first rigid region. The first flexible printed circuit board 510 may extend from the second rigid region in the region 500A or may be connected to the second printed circuit board 432 through a connector formed in the second rigid region. According to an embodiment, the second flexible printed circuit board 520 may extend from the third rigid region in the region 500B or may be connected to the third printed circuit board 433 through a connector formed in the third rigid region. The second flexible printed circuit board 510 may extend from the fourth rigid region in the region 500A or may be connected to the second printed circuit board 432 through a connector formed in the fourth rigid region.

According to an embodiment, the first flexible region of the first flexible printed circuit board 510 and the second flexible region of the second flexible printed circuit board 520 may correspond to the region 500C located between the region 500A and the region 500B. For example, the first flexible region and the second flexible region may be disposed between the first sidewall 591 and the second sidewall 592. The first flexible region of the first flexible printed circuit board 510 may be spaced apart from the second flexible region of the second flexible printed circuit board 520 and may overlap the second flexible region of the second flexible printed circuit board 520 when the second support member 420 is viewed from the side.

Referring back to FIG. 5, the first flexible region of the first flexible printed circuit board 510 and the second flexible region of the second flexible printed circuit board 520 may comprise curved surfaces 501C and planar surfaces 501A and 501B. For example, when the electronic device 200 is located in a first state movable in the first direction (+y direction), each of the first printed circuit board 510 and the second printed circuit board 520 may comprise planar surfaces 501A and 501B extending in a third direction (e.g., -x direction) perpendicular to the first direction (+y direction) from both ends of the curved surface 501C and the curved surface 501C. For example, when the electronic device is in the first state, a planar surface 501A contacting the first sidewall 591 among the planar surfaces 501A and 501B may extend from the first rigid region along the first sidewall 591, and a planar surface 501B contacting the second sidewall 592 among the planar surfaces 501A and 501B may extend from the second rigid region along the second sidewall 592.

According to an embodiment, the curved surface 501C may be convex in the first direction (+y direction) with respect to the planar surface 501B close to the second support member 420. However, in the first state, the shapes of the first flexible printed circuit board 510 and the second flexible printed circuit board 520 are not limited thereto. For example, the curved surface 501C of the first flexible region of the first printed circuit board 510 and the second flexible region of the second printed circuit board 520 may be convex in the second direction (-y direction) with respect to the planar surface 501A close to the first support member 410.

According to an embodiment, when the electronic device 200 is in the first state, the second sidewall 592 of the second support member 420 may comprise a seating portion in which a curved surface 501C of the flexible region of the first flexible printed circuit board 510 and the second flexible printed circuit board 520 is located. The seating portion may be formed in a shape corresponding to the shape of the curved surface 501C in the first state. The second support member 420 may further comprise a seating portion recessed in the first direction (+y direction) with respect to the second sidewall 592, and the curved surface 501C may be seated on the seating portion when the electronic device 200 is in the first state.

Referring to FIG. 6, the planar surfaces 501A and 501B and the curved surface 501C in the first state may be located in the region 500C as the electronic device 200 is converted to the second state. The shape of the flexible region located in the region 500C may change according to the state of the electronic device. The flexible region may be located in the space of the second support member 420 formed between the second printed circuit board 432 and the third printed circuit board 433. The region 500c corresponding to the curved surface 501C may be formed on the first sidewall 591 of the first housing 210 or the second sidewall 592 of the second housing 220. For example, the curved surface 501C may be a groove formed in the first sidewall 591 of the first housing 210 or a groove formed in the second sidewall 592 of the second housing 220.

According to the above-described embodiment, the electronic device 200 may comprise the second printed circuit board 432 located in the moving second housing 220 or the second support member 420, and flexible printed circuit boards 510, 520 connecting the first printed circuit board 431 or the third printed circuit board 433 located in the fixed first housing 210 or the first support member 410. The flexible printed circuit boards 510 and 520 may be formed of a plurality of flexible printed circuit boards. Each of the plurality of flexible printed circuit boards 510 and 520 may be formed to have a thin thickness. The flexible printed circuit boards 510 and 520 formed with a thin thickness may change from a folded shape to an unfolded shape according to a change in the state of the electronic device 200. When the thickness of the flexible printed circuit board is increased by including the signal line and the power line in one flexible printed circuit board, the flexibility of the flexible printed circuit board may be weakened and may be damaged by frequent deformation. By means of using flexible printed circuit boards, damage caused by deformation can be prevented.

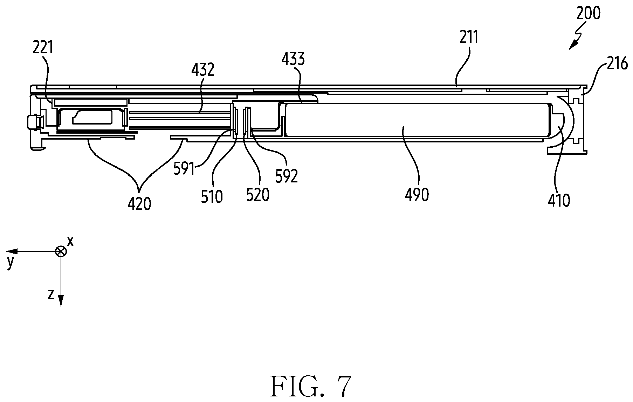

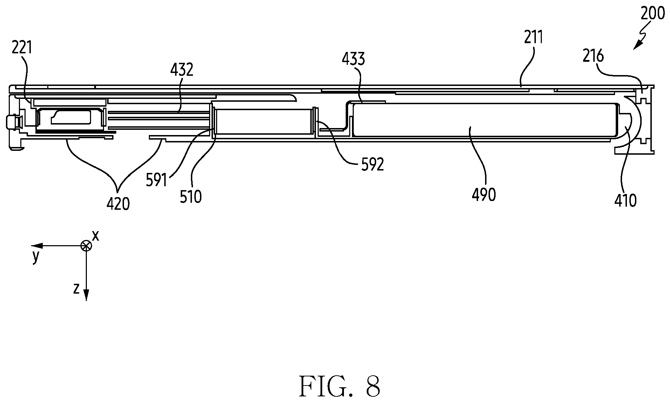

FIG. 7 shows a cross-sectional view of an electronic device in a first state. FIG. 8 shows a cross-sectional view of an electronic device in a second state.

Referring to FIGS. 7 and 8, the first flexible printed circuit board 510 and the second flexible printed circuit board 520 may be spaced apart from each other. Widths of the first printed circuit board 510 and the second printed circuit board 520 may be disposed perpendicular to the second support member 420. For example, the first flexible printed circuit board 510 and the second flexible printed circuit board 520 may be formed as a surface perpendicular to one surface of the first printed circuit board 431 facing the display (e.g., the display 230 in FIG. 2). The first flexible region of the first printed circuit board 431 and the second flexible region of the second printed circuit board 432 may be formed as a surface perpendicular to one surface of the first printed circuit board 431. Since the flexible printed circuit board 510 and the second flexible printed circuit board 520 vertically disposed on the second support member 420 may have higher space efficiency than the first flexible printed circuit board 510 and the second flexible printed circuit board 520 horizontally disposed on the second support member 420, the thickness of the electronic device 200 may be reduced.

According to an embodiment, when the electronic device 200 is in the second state, the first flexible printed circuit board 510 may overlap a portion of the second flexible printed circuit board 520 when viewed from the side of the electronic device 200 of the first flexible printed circuit board 510. For example, the first flexible region of the first flexible printed circuit board 510 may be spaced apart from the second flexible region of the second flexible printed circuit board 520, and may overlap the second flexible region when the second support member 420 is viewed in a direction (e.g., the -x direction) perpendicular to the direction (e.g., z direction) display (e.g., display 230 of FIG. 2) facing.

According to an embodiment, the first support member 410 may comprise a first sidewall 591 disposed along a side surface facing the second support member 420. The second support member 420 may comprise a second sidewall 592 disposed along a side surface facing the first sidewall 591. According to an embodiment, a portion of the first flexible printed circuit board 510 and a portion of the second flexible printed circuit board 520 may be disposed between the first sidewall 591 and the second sidewall 592. For example, the first flexible region of the first flexible printed circuit board 510 and the second flexible region of the second flexible printed circuit board 520 may be disposed between the first sidewall 591 and the second sidewall 592.

According to an embodiment, in a first state in which the second support member 420 may move in the first direction (+y direction) among the first direction (+y direction) and the second direction (-y direction) opposite to the first direction (+y direction), the distance between the first sidewall 591 and the second sidewall 592 may be narrower than the distance between the first sidewall 591 and the second sidewall 592 in a second state in which the second support member 420 may move in the second direction (-y direction). According to one embodiment, when the slide cover 221 coupled to the second support member 420 is slid into the space formed by the rear plate 211 and the book cover 216, the distance between the first sidewall 591 and the second sidewall 592, may be narrower than the distance between the first sidewall 591 and the second sidewall 592 when the slide cover 221 is slid out from the space formed by the book cover 216 and the rear plate 211. According to an embodiment, the first flexible printed circuit board 510 and the second flexible printed circuit board 520, when the electronic device 200 is in the second state, may be unfolded in a space between the first sidewall 591 and the second sidewall 592.

According to the above-described embodiment, the electronic device 200 may connect a second printed circuit board 432 disposed on the second support member 420 and a first printed circuit board 431 disposed on the first support member 410 (e.g., the first printed circuit board 431 of FIG. 4) or the third printed circuit board 433 through a plurality of flexible printed circuit boards 510 and 520. The plurality of flexible printed circuit boards 510 and 520 may be vertically disposed on the first support member 410 and the second support member 420, thereby increasing space efficiency. The flexible region of each of the flexible printed circuit boards 510 and 520 may change without damage in response to a change in the state of the electronic device 200 by forming a thin thickness of each of the flexible printed circuit boards.

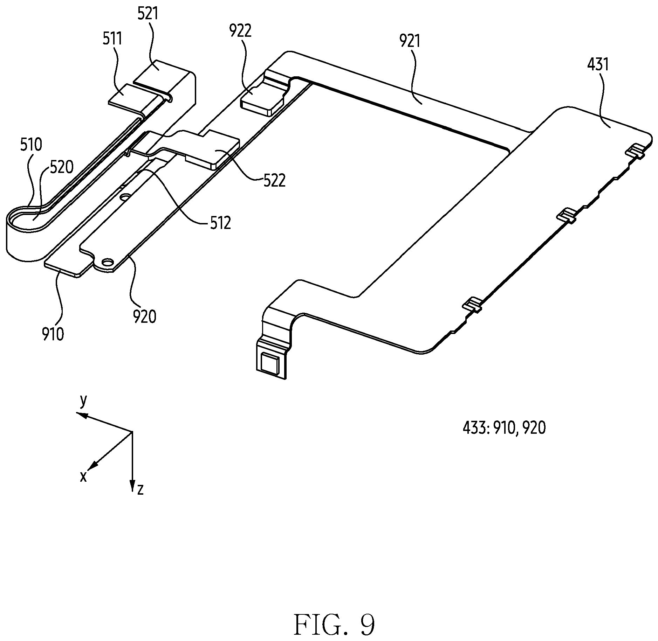

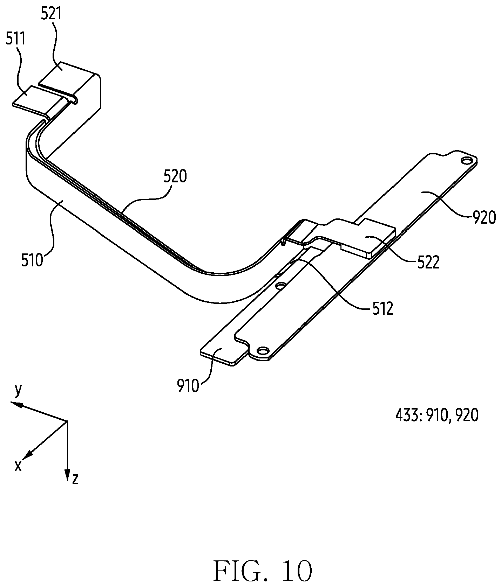

FIG. 9 shows a disposition of the flexible printed circuit board in a first state. FIG. 10 shows a disposition of the flexible printed circuit board in a second state.

Referring to FIGS. 9 and 10, the first flexible printed circuit board 510 and the second flexible printed circuit board 520 may be disposed to overlap each other. According to an embodiment, the third printed circuit board 433 may comprise a first rigid region 910 and a second rigid region 920. The first rigid region 910 and the second rigid region 920 may be connected to each other through a flexible portion.

According to an embodiment, the second flexible printed circuit board 520 may comprise a first connector 522 coupled to the first conductive pad of the third printed circuit board 433 and a second connector 521 coupled to the second conductive pad of the second printed circuit board 432. The first flexible printed circuit board 510 may comprise a third connector 511 coupled to the third conductive pad of the second printed circuit board.

According to an embodiment, the third printed circuit board 433 may comprise a first conductive pad connected to the second flexible printed circuit board 520. The second printed circuit board 432 (e.g., the second printed circuit board 432 of FIG. 4) may comprise a second conductive pad connected to the second flexible printed circuit board 520 and a third conductive pad connected to the first flexible printed circuit board 510.

According to an embodiment, the third printed circuit board 433 may be integrally formed with the first flexible printed circuit board 510. The first rigid region 910 may be connected to the first flexible printed circuit board 510. For example, the first flexible printed circuit board 510 may dispose a conductive pattern and/or a conductive portion extending from the third printed circuit board 433 on a flexible board. The first flexible printed circuit board 510 and the third printed circuit board 433 may be formed of a rigid flexible printed circuit board (RFPCB). The first rigid region 910 of the third printed circuit board 433 may have rigidity, and the first flexible printed circuit board 510 extending from the first rigid region 910 may have flexibility.

According to an embodiment, the third printed circuit board 433 may be connected to the first connector 522 extending from the second flexible printed circuit board 520 through the first conductive pad. The second rigid region 920 of the third printed circuit board 433 may be connected to the second flexible printed circuit board 520 through the first connector 522.

The third printed circuit board 433 may be coupled to a fourth connector 922 mounted on an extension portion 921 extending from the first printed circuit board 431. For example, the third printed circuit board 433 and the first printed circuit board 431 may be electrically connected through the fourth connector 922. The first printed circuit board 431 may be electrically connected to an antenna module disposed in the first housing (e.g., the first housing 210 of FIG. 2). According to an embodiment, the wireless communication signal received from the outside through the antenna module may be transmitted to the first printed circuit board 431 through the second flexible printed circuit board.

According to an embodiment, the flexible regions of the first flexible printed circuit board 510 and the second flexible printed circuit board 520 may have a width perpendicular to the first printed circuit board 431 and the third printed circuit board 433. For example, the first flexible printed circuit board 510 may comprise a connection portion 512 extending from the first rigid region 910 in the first direction (+y direction). The first flexible printed circuit board 510 may be bent in the -z direction from the connection portion 512 and then extend in the +x direction, thereby including a flexible region having a width perpendicular to the surface of the third printed circuit board 433. The second flexible printed circuit board 520 may extend in a first direction (+y direction) from the first connector 522 coupled to the second rigid region 920. The first flexible printed circuit board 510 may be bent in the +z direction from the first connector 522 and then extended in the +x direction, thereby including a flexible region having a width perpendicular to the surface of the third printed circuit board 433.

Referring to FIG. 9, the first flexible printed circuit board 510 and the second flexible printed circuit board 520 may have a folded shape when an electronic device (e.g., electronic device 200 of FIG. 2) is in a first state (e.g., closed state). For example, the first flexible printed circuit board 510 and the second flexible printed circuit board 520 may have a region formed of a curved surface (e.g., curved surface 501C in FIG. 5) and a remaining region. The remaining regions of the first flexible printed circuit board 510 may be planar surfaces facing each other (e.g., planar surfaces 501A and 501B of FIG. 5). For example, a direction to which one of the planar surfaces of the first flexible printed circuit board 510 faces and a direction to which the other one faces may be the same as or opposite to each other.

Referring to FIG. 10, the first flexible printed circuit board 510 and the second flexible printed circuit board 520 may have a shape in which a flexible region is unfolded when the electronic device 200 is in a second state (e.g., open state). For example, the first flexible printed circuit board 510 and the second flexible printed circuit board 520 may be unfolded, except for some bending region in the folded portion from the fixing portion extending from the connector (e.g., the first connector 522, the second connector 521, and/or the third connector 511).

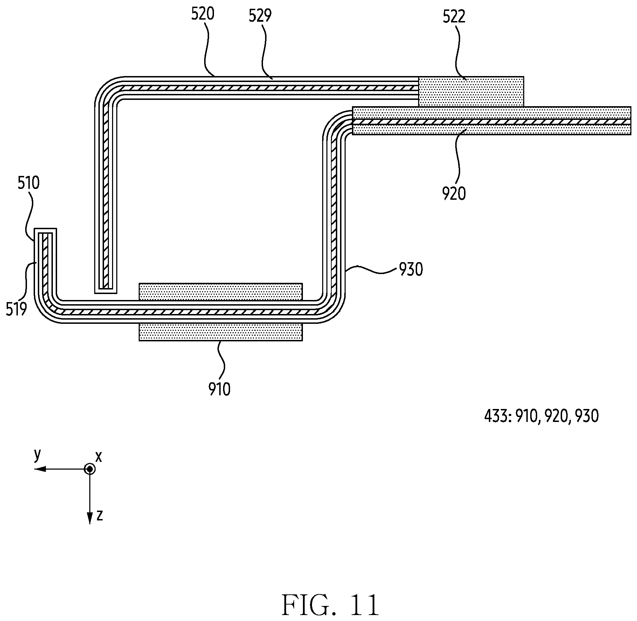

FIG. 11 is a cross-sectional view that the flexible printed circuit board and the third printed circuit board of FIG. 9.

The first flexible printed circuit board 510 and the second flexible printed circuit board 520 may comprise a transmission line therein. The first flexible printed circuit board 510 may be connected to the first rigid region 910 of the third printed circuit board 433. The first flexible printed circuit board 510 and the first rigid region 910 may be integrally formed with each other. The first flexible printed circuit board 510 may be formed by extending a conductive pattern in the first rigid region 910. The second flexible printed circuit board 520 may be electrically connected to the second rigid region 920 through the first connector 522.

According to an embodiment, the first flexible printed circuit board 510 may extend in the +y direction from the first rigid region 910, and then may be folded in the -z direction. The first flexible printed circuit board 510 may extend in the +x direction after being bent. The second flexible printed circuit board 510 may extend along the +y direction from the first connector 522 coupled to the second rigid region 920, and then may be folded in the +z direction. The second flexible printed circuit board 520 may extend in the +x direction after being bent.

According to an embodiment, the first flexible printed circuit board 510 may comprise a first transmission line therein, and the second flexible printed circuit board 520 may comprise a second transmission line therein. The first transmission line of the first flexible printed circuit board 510 may be a line for transmitting data or a control signal. However, it is not limited thereto. The second transmission line of the second flexible printed circuit board 520 may be a line providing a control signal or data supplied to electronic component disposed on the first support member 410 (e.g., first support member 410 of FIG. 4) or an integrated circuit disposed on the third printed circuit board 433, or an integrated circuit board disposed on the first printed circuit board 431(e.g., the first printed circuit board 431 of FIG. 3) connected to the third printed circuit board 433. For another example, the second transmission line of the second flexible printed circuit board 520 may be a line that supplies power supplied from a battery (e.g., the battery 490 of FIG. 4) disposed in the first support member 410 to an electronic component disposed on the second printed circuit board (e.g., the second printed circuit board 432 of FIG. 4).

According to an embodiment, as described above, the flexible regions of the first flexible printed circuit board 510 and the second flexible printed circuit board 520 may be formed to have a width perpendicular to a surface of the third printed circuit board 433. When the first flexible printed circuit board 510 and the second flexible printed circuit board 520 are formed in a planar surface parallel to the third printed circuit board 433 or have a width parallel to the third printed circuit board 433, a large space may be required in the z-axis direction to secure a space of the flexible printed circuit board according to a state change of the electronic device 200. In order to increase space efficiency, the flexible regions of the first flexible printed circuit board 510 and the second flexible printed circuit board 520 may have a width perpendicular to the third printed circuit board 433.

According to an embodiment, the first flexible printed circuit board 510 and the second flexible printed circuit board 520 may be configured to be deformable according to a state change of the electronic device 200. For example, the width of the first flexible printed circuit board 510 and the second flexible printed circuit board 520 may be formed to be lower than the thickness of the electronic device 200, so that the first flexible printed circuit board 510 and the second flexible printed circuit board 520 may be disposed in a space between the first support member 410 and the second support member 420. The width of the first flexible printed circuit board 510 and the second flexible printed circuit board 520 may be limited by the thickness of the electronic device 200. When the first flexible printed circuit board 510 and the second flexible printed circuit board 520 are integrally formed, the thickness of the flexible printed circuit board may be increased by a limited width. Since the thickened flexible printed circuit board has weakened flexibility, damage may occur due to repeated deformation of the flexible printed circuit board depending on the state of the electronic device. To prevent damage, the electronic device may configure a plurality of flexible printed circuit boards connecting the second printed circuit board 432 and the third printed circuit board 433.

According to an embodiment, the first flexible printed circuit board 510 may further comprise a first conductive layer 519 surrounding the first transmission line. The second flexible printed circuit board 520 may further comprise a second conductive layer 529 surrounding the signal line. Since the first flexible printed circuit board 510 and the second flexible printed circuit board 520 overlap each other and are disposed close to each other, signals transmitted through the transmission line of the first flexible printed circuit board 510 and the transmission line of the second flexible printed circuit board 520 may affect each other. A signal transmitted through the first flexible printed circuit board 510 may occur interference due to a signal transmitted through the second flexible printed circuit board 520. In order to prevent interference between two adjacent lines, the first flexible printed circuit board 510 and the second flexible printed circuit board 520 may comprise conductive layers 519 and 529. The conductive layers 519 and 529 may comprise a shielding film or a copper foil.

According to the above-described embodiment, a flexible printed circuit board for connecting a printed circuit board (e.g., a third printed circuit board 433) disposed on the first support member 410 and a printed circuit board (e.g., a second printed circuit board 432) disposed on the second support member 420 may comprise a plurality of flexible printed circuit boards 510 and 520 to ensure flexibility. In order to reduce interference of signals transmitted through the plurality of flexible printed circuit boards 510 and 520, the flexible printed circuit boards 510 and 520 may comprise a conductive layer surrounding the signal line.

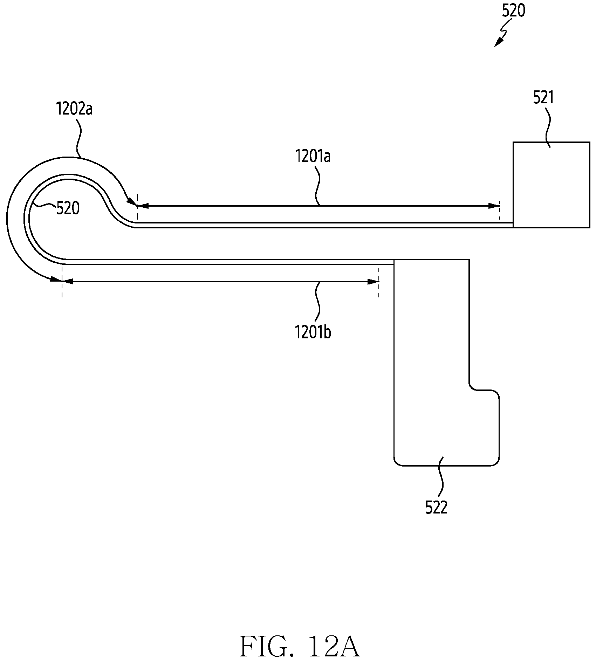

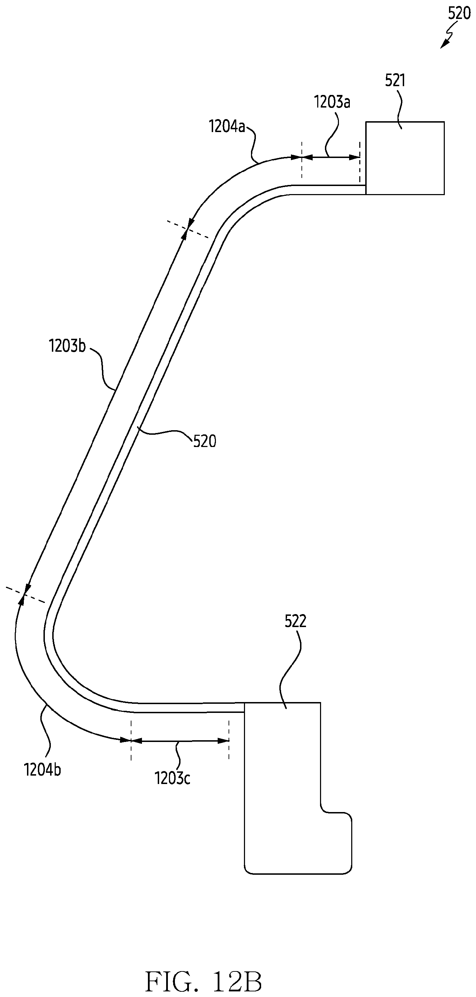

FIG. 12A shows a shape of a flexible printed circuit board in a first state. FIG. 12B shows a deformed shape of a flexible printed circuit board in a second state.

Referring to FIG. 12A, when the electronic device (e.g., electronic device 200 of FIG. 2A) is in the first state, the flexible printed circuit board 520 (e.g., second flexible printed circuit board 520) may comprise unfolded areas 1201a, 1201b and a folded area 1202a.

According to an embodiment, the unfolded areas 1201a and 1201b may correspond to the planar surfaces 501A and 501B of FIG. 5. The folded area 1202a may correspond to the curved surface 501C of FIG. 5. The flexible printed circuit board 520 may comprise a rigid member in at least a portion of the unfolded areas 1201a and 1201b. The flexible printed circuit board 520 may maintain the shape of the unfolded areas 1201a and 1201b in the first state by the rigid member. The flexible printed circuit board 520 may comprise a flexible member in the folded area 1202a. The flexible printed circuit board 520 may form the folded area 1202a in the first state by the flexible member. A connection region between the flexible printed circuit board 520 and the connectors 521 and 522 may be connected by a flexible member.

Referring to FIG. 12B, when the electronic device 200 is in the second state, the flexible printed circuit board 520 may comprise unfolded areas 1203a, 1203b, and 1203c and folded areas 1204a and 1204b.

According to an embodiment, the unfolded areas 1203a, 1203b, and 1203c may correspond to a portion of the unfolded flexible printed circuit board 520 in the second state. The folded areas 1204a and 1204b may correspond to a portion of the folded flexible printed circuit board 520 in the second state. The flexible printed circuit board 520 may comprise a rigid member in at least a portion of the unfolded areas 1203a, 1203b, and 1203c. The flexible printed circuit board 520 may maintain the shape of the unfolded areas 1203a, 1203b, and 1203c in the second state by the rigid member. The flexible printed circuit board 520 may comprise a flexible member in the folded areas 1202a and 1202b.

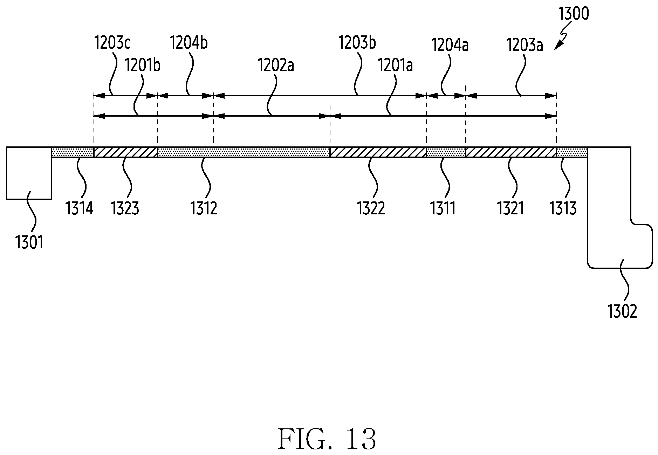

Referring to FIGS. 12A and 12B, in the first state, in the folded areas 1202a and the second state, in the folded areas 1204a and 1204b, the flexible printed circuit board 520 may have flexibility to be deformable, and the remaining regions may have rigidity to maintain their shape. The internal configuration of the flexible printed circuit board 520 will be described later with reference to FIG. 13.

In the above-described embodiments, the flexible printed circuit board 520 is expressed as including a rigid member and a flexible member, but is not limited thereto and may comprise only the flexible member.

FIG. 13 schematically shows a configuration of a flexible printed circuit board.

Referring to FIG. 13, the flexible printed circuit board 1300 may comprise flexible members 1311, 1312, 1313, and 1314 and rigid members 1321, 1322, and 1323. The flexible members 1311, 1312, 1313, and 1314 may be disposed on a portion of the flexible printed circuit board 1300 requiring flexibility. For example, the areas corresponding to the folded area 1202a when the electronic device 200 (e.g., the electronic device 200 of FIG. 2A) is in the first state, and the folded areas 1204a and 1204b when the electronic device 200 is in the second state may be areas in which some of the flexible members 1311 and 1312 are disposed. For example, the first flexible member 1311 may be disposed in a partial region 1204a of the folded area in the second state, and the second flexible member 1312 may be disposed in the folded area 1202a in the first state and the remaining region 1204b of the folded area in the second state. The first flexible member 1311 and the second flexible member 1312 may be disposed in a region in which the flexible printed circuit board 1300 is deformed according to a change in the state of the electronic device 200.

According to an embodiment, the folded area 1202a in the first state corresponding to the curved surface 501C of FIG. 5 may have a length for forming a large diameter of the curved surface 501C to secure durability of the flexible printed circuit board 1300. For example, in order to secure the length of the folded area 1202a in the first state, the length of the second flexible member 1312 may be increased. The length of the second flexible member 1312 may be formed to be proportional to a radius of curvature of the curved surface 501C.

According to an embodiment, the third flexible member 1313 and the fourth flexible member 1314 may be disposed at a connection region between the flexible printed circuit board 1300 and the connectors 1301 and 1302. The third flexible member 1313 may be disposed between the first rigid member 1321 and the second connector 1302, and the fourth flexible member 1314 may be disposed between the third rigid member 1323 and the first connector 1301.

According to an embodiment, the rigid members 1321, 1322, and 1323 may be comprised in a region requiring shape maintenance of the flexible printed circuit board 1300. The flexible printed circuit board 1300 may comprise conductive vias in the rigid members 1321, 1322, and 1323. The rigid members 1321, 1322, and 1323 of the flexible printed circuit board 1300 may maintain a constant shape when a state of the electronic device (e.g., a slide-in or slide-out state) changes. For example, the first rigid member 1321 may correspond to the area 1203a in which the electronic device 200 is unfolded in the second state. The first rigid member 1321 may be disposed on a portion of the area 1201a in which the electronic device 200 is unfolded in the first state. The area 1201a in which the electronic device 200 is unfolded in the first state may comprise a first rigid member 1321, a second rigid member 1322, and a first flexible member 1311. The area 1201a in which the electronic device 200 of the flexible printed circuit board 1300 is unfolded in the first state may comprise a first rigid member 1321 and a second rigid member 1322 to maintain the shape of the unfolded area 1201a. The area 1201a in which the electronic device 200 is unfolded in the first state may comprise a first flexible member 1311 to form a folded area 1204a in the second state when the electronic device 200 changes from the first state to the second state. For example, the flexible printed circuit board 1300 may comprise rigid members 1321, 1322, and 1323 in remaining regions other than the region requiring flexibility in which the flexible members 1311, 1312, 1313, and 1314 are disposed. The second rigid member 1322 may be disposed in a portion of the unfolded area 1201a in the first state of the electronic device and a portion of the unfolded area 1203b in the second state. The area 1203b in which the electronic device 200 is unfolded in the second state may comprise the second rigid member 1322 in a portion excluding the area 1202a. The third rigid member 1323 may be disposed in a region corresponding to a portion of the area 1201b in which the electronic device 200 is unfolded in the first state and the area 1203c in which the electronic device 200 is unfolded in the second state. The rigid members 1321, 1322, and 1323 may be disposed in a region excluding the regions 1202a, 1204a, and 1204b folded in the first state or the second state.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with,", "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device (200) comprising:
a first housing (210);
a second housing (220) slidably coupled to the first housing (210) in a first direction;
a flexible display (230) expanding in the first direction or contracting in a second direction opposite to the first direction, based on a slide-in state or slide-out state of the second housing (220);
a first printed circuit board (431) disposed in the first housing (210);
a second printed circuit board (432) disposed in the second housing (220);
a first flexible printed circuit board (510) connecting the first printed circuit board (431) and the second printed circuit board (432), and folded or unfolded based on slide-in or slide-out of the second housing (220); and
a second flexible printed circuit board (520) connecting the first printed circuit board (431) and the second printed circuit board (432), and folded or unfolded based on slide-in or slide-out of the second housing (220),
wherein the first flexible printed circuit board (510) includes:
a first rigid region (500A) connected to the first printed circuit board (431);
a second rigid region (500B) connected to the second printed circuit board (432); and
a flexible region (500C), disposed between the first and second rigid regions (500A, 500B) of the first flexible printed circuit board (510), being folded based on the slide-in state of the second housing (220),
wherein the second flexible printed circuit board (520) includes:
a third rigid region (500A) connected to the first printed circuit board (431);
a fourth rigid region (500B) connected to the second printed circuit board (432); and
a flexible region (500C), disposed between the third and fourth rigid regions (500A, 500B) of the second flexible printed circuit board (520), being folded based on the slide-in state of the second housing (220), and
wherein the first flexible printed circuit board (510) is configured to transmit a radio frequency, RF, signal from among the RF signal and a power signal, and the second flexible printed circuit board (520) is configured to transmit the power signal from among the RF signal and the power signal.

2. The electronic device (200) of claim 1, wherein the first flexible printed circuit board (510) or the second flexible printed circuit board (520) include a shielding film; and/or
wherein the flexible region (500C) of the first flexible printed circuit board (510) and the flexible region (500C) of the second flexible printed circuit board (520) is perpendicular to a surface of the first printed circuit board (431) facing the flexible display (230).

3. The electronic device (200) of claim 1 or claim 2, wherein the first housing (210) includes a first sidewall disposed along a side surface of the first housing (210) facing the second housing (220),
wherein the second housing (220) includes a second sidewall disposed along a side surface of the second housing (220) facing the first sidewall, and
wherein the flexible region (500C) is disposed between the first sidewall and the second sidewall,
wherein a distance between the first sidewall and the second sidewall, in a first state in which the second housing (220) is movable in the first direction among the first direction and a second direction opposite to the first direction is preferably narrower than a distance between the first sidewall and the second sidewall, in a second state in which the second housing (220) is movable in the second direction.

4. The electronic device (200) of any one of claims 1 to 3, wherein the first rigid region (500A) of the first flexible printed circuit board (510) and the third rigid region (500A) of the second flexible printed circuit board (520) is fixed by a slit disposed at the first sidewall.

5. The electronic device (200) of any one of claims 1 to 4, wherein the flexible region (500C) includes a curved surface and planar surfaces extending in a third direction perpendicular to the first direction at both ends of the curved surface, in a first state in which the second housing (220) is movable in the first direction among the first direction and a second direction opposite to the first direction and
wherein the curved surface is convex in the first direction from a planar surface among the planar surfaces closer to the second housing (220).

6. The electronic device (200) of claim 5,
wherein a planar surface among the planar surfaces in contact with the first sidewall of the first housing (210) extends from the first rigid region (500A) along the first sidewall, in the first state, and
wherein a planar surface among the planar surfaces in contact with the second sidewall of the second housing (220) extends from the second rigid region (500B) along the second sidewall.

7. The electronic device (200) of any one of claims 1 to 6, wherein the first housing (210) includes a first sidewall disposed along a side surface of the first housing (210) facing the second housing (220),
wherein the second housing (220) includes a second sidewall disposed along a side surface of the second housing (220) facing the first sidewall, and
wherein the second housing (220) further includes a seating portion recessed in the first direction with respect to the second sidewall of the second housing (220) facing the first sidewall of the first housing (210), and
wherein the curved surface is seated on the seating portion when the electronic device (200) is in the first state.

8. The electronic device (200) of any one of claims 1 to 7, wherein the second flexible printed circuit board (520) is configured to transmit data or a control signal from at least one processor disposed on the first printed circuit board (431) to an electronic component disposed on the second printed circuit board (432).

9. The electronic device (200) of any one of claims 1 to 8, wherein the first printed circuit board (431) includes a first conductive pad connected to the second flexible printed circuit board (520),
wherein the second printed circuit board (432) includes a second conductive pad connected to the second flexible printed circuit board (520) and a third conductive pad connected to the first flexible printed circuit board (510),
wherein the second flexible printed circuit board (520) includes a first connector coupled to the first conductive pad and a second connector coupled to the second conductive pad, and
wherein the first flexible printed circuit board (510) includes a third connector coupled to the third conductive pad.

10. The electronic device (200) of any one of claims 1 to 9, further comprising a third printed circuit board (433) disposed in the first housing (210),
wherein the first printed circuit board (431) includes a transmission line electrically connected to the third printed circuit board (433),
wherein the first printed circuit board (431) preferably includes a first board, a second board having a step difference from the first board, and a connection board connecting the first board and the second board,
wherein the first board is connected to the first flexible printed circuit board (510), and
wherein the second board is connected to the second flexible printed circuit board (520).

11. The electronic device (200) of any one of claims 1 to 10, further comprising:
a battery disposed in the first housing (210);
an actuator (441) disposed in the first housing (210);
a pinion gear (442) coupled to a rotation shaft of the actuator (441); and
a rack gear (443) disposed in the second housing (220) and including a plurality of teeth engaged with the pinion gear (442).

12. The electronic device of claim 11, wherein the second flexible printed circuit board (520) is configured to transmit power supplied from the battery through the first circuit board(431) to the second printed circuit board (432).

13. The electronic device (200) of claim 11 or claim 12, wherein the second flexible printed circuit board (520) is configured to transmit a control signal from at least one processor disposed on the second printed circuit board (432) to the actuator (441).

14. The electronic device of any one of claims 1 to 13, wherein the second flexible printed circuit board (520) includes a signal line and a conductive layer distinct from the signal line.

15. The electronic device (200) of any one of claims 1 to 14, wherein conductive vias are formed in at least one of:
the first rigid region (500A) of the first flexible printed circuit board (510);
the second rigid region (500B) of the first flexible printed circuit board (510);
the third rigid region (500A) of the second flexible printed circuit board (520); or
the fourth rigid region (500B) of the second flexible printed circuit board (520),
wherein the flexible region (500C) is deformed to correspond to a groove formed in the first housing (210) or the second housing (220).

## Patentansprüche

1. Elektronische Vorrichtung (200), umfassend:
ein erstes Gehäuse (210);
ein zweites Gehäuse (220), das in einer ersten Richtung verschiebbar mit dem ersten Gehäuse (210) gekoppelt ist;
eine flexible Anzeige (230), die sich basierend auf einem Einschiebezustand oder Ausschiebezustand des zweiten Gehäuses (220) in der ersten Richtung ausdehnt oder in einer zweiten, der ersten Richtung entgegengesetzten Richtung zusammenzieht;
eine erste Leiterplatte (431), die in dem ersten Gehäuse (210) angeordnet ist;
eine zweite Leiterplatte (432), die in dem zweiten Gehäuse (220) angeordnet ist;
eine erste flexible Leiterplatte (510), die die erste Leiterplatte (431) und die zweite Leiterplatte (432) verbindet und basierend auf dem Einschieben oder Herausschieben des zweiten Gehäuses (220) gefaltet oder entfaltet wird; und
eine zweite flexible Leiterplatte (520), die die erste Leiterplatte (431) und die zweite Leiterplatte (432) verbindet und basierend auf dem Einschieben oder Herausschieben des zweiten Gehäuses (220) gefaltet oder entfaltet wird,
wobei die erste flexible Leiterplatte (510) umfasst:
einen ersten starren Bereich (500A), der mit der ersten Leiterplatte (431) verbunden ist;
einen zweiten starren Bereich (500B), der mit der zweiten Leiterplatte (432) verbunden ist; und
einen flexiblen Bereich (500C), der zwischen dem ersten und dem zweiten starren Bereich (500A, 500B) der ersten flexiblen Leiterplatte (510) angeordnet ist und basierend auf dem Einschiebezustand des zweiten Gehäuses (220) gefaltet ist,
wobei die zweite flexible Leiterplatte (520) umfasst:
einen dritten starren Bereich (500A), der mit der ersten Leiterplatte (431) verbunden ist;
einen vierten starren Bereich (500B), der mit der zweiten Leiterplatte (432) verbunden ist; und
einen flexiblen Bereich (500C), der zwischen dem dritten und vierten starren Bereich (500A, 500B) der zweiten flexiblen Leiterplatte (520) angeordnet ist und basierend auf dem Einschiebezustand des zweiten Gehäuses (220) gefaltet ist, und
wobei die erste flexible Leiterplatte (510) konfiguriert ist, um ein Hochfrequenz-, HF,-Signal aus dem HF-Signal und einem Leistungssignal zu übertragen, und die zweite flexible Leiterplatte (520) konfiguriert ist, um das Leistungssignal aus dem HF-Signal und dem Leistungssignal zu übertragen.

2. Elektronische Vorrichtung (200) nach Anspruch 1, wobei die erste flexible Leiterplatte (510) oder die zweite flexible Leiterplatte (520) einen Abschirmungsfilm enthält; und/oder
wobei der flexible Bereich (500C) der ersten flexiblen Leiterplatte (510) und der flexible Bereich (500C) der zweiten flexiblen Leiterplatte (520) senkrecht zu einer der flexiblen Anzeige (230) zugewandten Oberfläche der ersten Leiterplatte (431) ist.

3. Elektronische Vorrichtung (200) nach Anspruch 1 oder Anspruch 2, wobei das erste Gehäuse (210) eine erste Seitenwand enthält, die entlang einer Seitenfläche des ersten Gehäuses (210) angeordnet ist, die dem zweiten Gehäuse (220) zugewandt ist,
wobei das zweite Gehäuse (220) eine zweite Seitenwand umfasst, die entlang einer der ersten Seitenwand zugewandten Seitenfläche des zweiten Gehäuses (220) angeordnet ist, und
wobei der flexible Bereich (500C) zwischen der ersten Seitenwand und der zweiten Seitenwand angeordnet ist,
wobei ein Abstand zwischen der ersten Seitenwand und der zweiten Seitenwand in einem ersten Zustand, in dem das zweite Gehäuse (220) in der ersten Richtung aus der ersten Richtung und einer zweiten, der ersten Richtung entgegengesetzten Richtung bewegbar ist, vorzugsweise schmaler ist als ein Abstand zwischen der ersten Seitenwand und der zweiten Seitenwand in einem zweiten Zustand, in dem das zweite Gehäuse (220) in der zweiten Richtung bewegbar ist.

4. Elektronische Vorrichtung (200) nach einem der Ansprüche 1 bis 3, wobei der erste starre Bereich (500A) der ersten flexiblen Leiterplatte (510) und der dritte starre Bereich (500A) der zweiten flexiblen Leiterplatte (520) durch einen an der ersten Seitenwand angeordneten Schlitz befestigt ist.

5. Elektronische Vorrichtung (200) nach einem der Ansprüche 1 bis 4, wobei der flexible Bereich (500C) eine gekrümmte Oberfläche und ebene Oberflächen enthält, die sich in einem ersten Zustand, in dem das zweite Gehäuse (220) in der ersten Richtung aus der ersten Richtung und der zweiten, der ersten Richtung entgegengesetzten Richtung bewegbar ist, in einer dritten Richtung senkrecht zu der ersten Richtung an beiden Enden der gekrümmten Oberfläche erstrecken, und
wobei die gekrümmte Oberfläche in der ersten Richtung von einer ebenen Oberfläche aus den ebenen Oberflächen näher zum zweiten Gehäuse (220) konvex ist.

6. Elektronische Vorrichtung (200) nach Anspruch 5,
wobei eine ebene Oberfläche aus den ebenen Oberflächen, die in Kontakt mit der ersten Seitenwand des ersten Gehäuses (210) steht, sich im ersten Zustand von dem ersten starren Bereich (500A) entlang der ersten Seitenwand erstreckt, und
wobei sich eine ebene Oberfläche aus den ebenen Oberflächen, die in Kontakt mit der zweiten Seitenwand des zweiten Gehäuses (220) steht, von dem zweiten starren Bereich (500B) entlang der zweiten Seitenwand erstreckt.

7. Elektronische Vorrichtung (200) nach einem der Ansprüche 1 bis 6, wobei das erste Gehäuse (210) eine erste Seitenwand enthält, die entlang einer Seitenfläche des ersten Gehäuses (210) angeordnet ist, die dem zweiten Gehäuse (220) zugewandt ist,
wobei das zweite Gehäuse (220) eine zweite Seitenwand umfasst, die entlang einer der ersten Seitenwand zugewandten Seitenfläche des zweiten Gehäuses (220) angeordnet ist, und
wobei das zweite Gehäuse (220) ferner einen Sitzabschnitt umfasst, der in der ersten Richtung in Bezug auf die zweite Seitenwand des zweiten Gehäuses (220), die der ersten Seitenwand des ersten Gehäuses (210) zugewandt ist, ausgespart ist, und
wobei die gekrümmte Oberfläche auf dem Sitzabschnitt aufsitzt, wenn sich die elektronische Vorrichtung (200) im ersten Zustand befindet.

8. Elektronische Vorrichtung (200) nach einem der Ansprüche 1 bis 7, wobei die zweite flexible Leiterplatte (520) konfiguriert ist, um Daten oder ein Steuersignal von mindestens einem auf der ersten Leiterplatte (431) angeordneten Prozessor an eine auf der zweiten Leiterplatte (432) angeordnete elektronische Komponente zu übertragen.

9. Elektronische Vorrichtung (200) nach einem der Ansprüche 1 bis 8, wobei die erste Leiterplatte (431) ein erstes leitendes Pad enthält, das mit der zweiten flexiblen Leiterplatte (520) verbunden ist,
wobei die zweite Leiterplatte (432) ein zweites leitendes Pad, das mit der zweiten flexiblen Leiterplatte (520) verbunden ist, und ein drittes leitendes Pad, das mit der ersten flexiblen Leiterplatte (510) verbunden ist, enthält,
wobei die zweite flexible Leiterplatte (520) einen ersten Verbinder, der mit dem ersten leitenden Pad gekoppelt ist, und einen zweiten Verbinder, der mit dem zweiten leitenden Pad gekoppelt ist, umfasst, und
wobei die erste flexible Leiterplatte (510) einen dritten Verbinder umfasst, der mit dem dritten leitenden Pad gekoppelt ist.

10. Elektronische Vorrichtung (200) nach einem der Ansprüche 1 bis 9, ferner umfassend eine dritte Leiterplatte (433), die in dem ersten Gehäuse (210) angeordnet ist,
wobei die erste Leiterplatte (431) eine Übertragungsleitung enthält, die elektrisch mit der dritten Leiterplatte (433) verbunden ist,
wobei die erste Leiterplatte (431) vorzugsweise eine erste Platte, eine zweite Platte mit einem Stufenunterschied zur ersten Platte und eine Verbindungsplatte, die die erste Platte und die zweite Platte verbindet, enthält,
wobei die erste Platte mit der ersten flexiblen Leiterplatte (510) verbunden ist, und
wobei die zweite Platte mit der zweiten flexiblen Leiterplatte (520) verbunden ist.

11. Elektronische Vorrichtung (200) nach einem der Ansprüche 1 bis 10, ferner umfassend:
eine im ersten Gehäuse (210) angeordnete Batterie;
einen im ersten Gehäuse (210) angeordneten Aktuator (441);
ein Ritzel (442), das mit einer Drehwelle des Aktuators (441) gekoppelt ist; und
eine Zahnstange (443), die in dem zweiten Gehäuse (220) angeordnet ist und eine Vielzahl von Zähnen umfasst, die mit dem Ritzel (442) in Eingriff stehen.

12. Elektronische Vorrichtung nach Anspruch 11, wobei die zweite flexible Leiterplatte (520) so konfiguriert ist, dass sie von der Batterie gelieferte Leistung über die erste Leiterplatte (431) auf die zweite Leiterplatte (432) überträgt.

13. Elektronische Vorrichtung (200) nach Anspruch 11 oder Anspruch 12, wobei die zweite flexible Leiterplatte (520) konfiguriert ist, um ein Steuersignal von mindestens einem auf der zweiten Leiterplatte (432) angeordneten Prozessor an den Aktuator (441) zu übertragen.

14. Elektronische Vorrichtung nach einem der Ansprüche 1 bis 13, wobei die zweite flexible Leiterplatte (520) eine Signalleitung und eine von der Signalleitung verschiedene leitende Schicht enthält.

15. Elektronische Vorrichtung (200) nach einem der Ansprüche 1 bis 14, wobei leitfähige Durchkontaktierungen in mindestens einem von Folgendem ausgebildet sind:
dem ersten starren Bereich (500A) der ersten flexiblen Leiterplatte (510);
dem zweiten starren Bereich (500B) der ersten flexiblen Leiterplatte (510);
dem dritten starren Bereich (500A) der zweiten flexiblen Leiterplatte (520); oder
dem vierten starren Bereich (500B) der zweiten flexiblen Leiterplatte (520),
wobei der flexible Bereich (500C) so verformt wird, dass er einer in dem ersten Gehäuse (210) oder dem zweiten Gehäuse (220) ausgebildeten Nut entspricht.

## Revendications

1. Dispositif électronique (200), comprenant :
un premier boîtier (210) ;
un deuxième boîtier (220) couplé de manière coulissante au premier boîtier (210) dans une première direction ;
un affichage flexible (230) s'étendant dans une première direction ou se contractant dans une deuxième direction opposée à la première direction, en se basant sur un état de glissement vers l'intérieur ou un état de glissement vers l'extérieur du deuxième boîtier (220) ;
une première carte de circuit imprimé (431) disposée dans le premier boîtier (210) ;
une deuxième carte de circuit imprimé (432) disposée dans le deuxième boîtier (220) ;
une première carte de circuit imprimé flexible (510) reliant la première carte de circuit imprimé (431) et la deuxième carte de circuit imprimé (432), et pliée ou dépliée en se basant sur le glissement vers l'intérieur ou le glissement vers l'extérieur du deuxième boîtier (220) ; et
une deuxième carte de circuit imprimé flexible (520) reliant la première carte de circuit imprimé (431) et la deuxième carte de circuit imprimé (432), et pliée ou dépliée en se basant sur le glissement vers l'intérieur ou le glissement vers l'extérieur du deuxième boîtier (220),
dans lequel la première carte de circuit imprimé flexible (510) comprend :
une première zone rigide (500A) reliée à la première carte de circuit imprimé (431) ;
une deuxième région rigide (500B) reliée à la deuxième carte de circuit imprimé (432) ; et
une région flexible (500C), disposée entre les première et deuxième régions rigides (500A, 500B) de la première carte de circuit imprimé flexible (510), étant pliée sur la base de l'état de glissement vers l'intérieur du deuxième boîtier (220),
dans lequel la deuxième carte de circuit imprimé flexible (520) comprend :
une troisième région rigide (500A) reliée à la première carte de circuit imprimé (431) ;
une quatrième région rigide (500B) reliée à la deuxième carte de circuit imprimé (432) ; et
une région flexible (500C), disposée entre les troisième et quatrième régions rigides (500A, 500B) de la deuxième carte de circuit imprimé flexible (520), étant pliée sur la base de l'état de glissement vers l'intérieur du deuxième boîtier (220), et
dans lequel la première carte de circuit imprimé flexible (510) est configurée pour transmettre un signal de radiofréquence, RF, parmi le signal RF et un signal d'alimentation, et la deuxième carte de circuit imprimé flexible (520) est configurée pour transmettre le signal d'alimentation parmi le signal RF et le signal d'alimentation.

2. Dispositif électronique (200) de la revendication 1, dans lequel la première carte de circuit imprimé flexible (510) ou la deuxième carte de circuit imprimé flexible (520) comprennent un film de blindage ; et/ou
dans lequel la région flexible (500C) de la première carte de circuit imprimé flexible (510) et la région flexible (500C) de la deuxième carte de circuit imprimé flexible (520) sont perpendiculaires à une surface de la première carte de circuit imprimé (431) faisant face à l'affichage flexible (230).

3. Dispositif électronique (200) de la revendication 1 ou de la revendication 2, dans lequel le premier boîtier (210) comprend une première paroi latérale disposée le long d'une surface latérale du premier boîtier (210) faisant face au deuxième boîtier (220),
dans lequel le deuxième boîtier (220) comprend une deuxième paroi latérale disposée le long d'une surface latérale du deuxième boîtier (220) faisant face à la première paroi latérale, et
dans lequel la région flexible (500C) est disposée entre la première paroi latérale et la deuxième paroi latérale,
dans lequel une distance entre la première paroi latérale et la deuxième paroi latérale, dans un premier état dans lequel le deuxième boîtier (220) est mobile dans la première direction parmi la première direction et une deuxième direction opposée à la première direction, est de préférence plus étroite qu'une distance entre la première paroi latérale et la deuxième paroi latérale, dans un deuxième état dans lequel le deuxième boîtier (220) est mobile dans la deuxième direction.

4. Dispositif électronique (200) de l'une quelconque des revendications 1 à 3, dans lequel la première région rigide (500A) de la première carte de circuit imprimé flexible (510) et la troisième région rigide (500A) de la deuxième carte de circuit imprimé flexible (520) sont fixées par une fente disposée au niveau de la première paroi latérale.

5. Dispositif électronique (200) de l'une quelconque des revendications 1 à 4, dans lequel la région flexible (500C) comprend une surface courbe et des surfaces planes s'étendant dans une troisième direction perpendiculaire à la première direction aux deux extrémités de la surface courbe, dans un premier état dans lequel le deuxième boîtier (220) est mobile dans la première direction entre la première direction et une deuxième direction opposée à la première direction et
dans lequel la surface courbe est convexe dans la première direction à partir d'une surface plane parmi les surfaces planes plus proches du deuxième boîtier (220).

6. Dispositif électronique (200) de la revendication 5,
dans lequel une surface plane parmi les surfaces planes en contact avec la première paroi latérale du premier boîtier (210) s'étend à partir de la première région rigide (500A) le long de la première paroi latérale, dans le premier état, et
dans lequel une surface plane parmi les surfaces planes en contact avec la deuxième paroi latérale du deuxième boîtier (220) s'étend depuis la deuxième région rigide (500B) le long de la deuxième paroi latérale.

7. Dispositif électronique (200) de l'une des revendications 1 à 6, dans lequel le premier boîtier (210) comprend une première paroi latérale disposée le long d'une surface latérale du premier boîtier (210) faisant face au deuxième boîtier (220),
dans lequel le deuxième boîtier (220) comprend une deuxième paroi latérale disposée le long d'une surface latérale du deuxième boîtier (220) faisant face à la première paroi latérale, et
dans lequel le deuxième boîtier (220) comprend en outre une partie d'assise évidée dans la première direction par rapport à la deuxième paroi latérale du deuxième boîtier (220) faisant face à la première paroi latérale du premier boîtier (210), et
dans lequel la surface courbe est assise sur la partie d'assise lorsque le dispositif électronique (200) est dans le premier état.

8. Dispositif électronique (200) de l'une quelconque des revendications 1 à 7, dans lequel la deuxième carte de circuit imprimé flexible (520) est configurée pour transmettre des données ou un signal de commande depuis au moins un processeur disposé sur la première carte de circuit imprimé (431) à un composant électronique disposé sur la deuxième carte de circuit imprimé (432).

9. Dispositif électronique (200) de l'une quelconque des revendications 1 à 8, dans lequel la première carte de circuit imprimé (431) comprend un premier plot conducteur connecté à la deuxième carte de circuit imprimé flexible (520),
dans lequel la deuxième carte de circuit imprimé (432) comprend un deuxième plot conducteur connecté à la deuxième carte de circuit imprimé flexible (520) et un troisième plot conducteur connecté à la première carte de circuit imprimé flexible (510),
dans lequel la deuxième carte de circuit imprimé flexible (520) comprend un premier connecteur couplé au premier plot conducteur et un deuxième connecteur couplé au deuxième plot conducteur, et
dans lequel la première carte de circuit imprimé flexible (510) comprend un troisième connecteur couplé au troisième plot conducteur.

10. Dispositif électronique (200) selon l'une quelconque des revendications 1 à 9, comprenant en outre une troisième carte de circuit imprimé (433) disposée dans le premier boîtier (210),
dans lequel la première carte de circuit imprimé (431) comprend une ligne de transmission connectée électriquement à la troisième carte de circuit imprimé (433),
dans lequel la première carte de circuit imprimé (431) comprend de préférence une première carte, une deuxième carte présentant une différence de pas par rapport à la première carte, et une carte de connexion connectant la première carte et la deuxième carte,
dans lequel la première carte est connectée à la première carte de circuit imprimé flexible (510), et
dans lequel la deuxième carte est connectée à la deuxième carte de circuit imprimé flexible (520).

11. Dispositif électronique (200) de l'une des revendications 1 à 10, comprenant en outre :
une batterie disposée dans le premier boîtier (210) ;
un actionneur (441) disposé dans le premier boîtier (210) ;
un pignon (442) couplé à un arbre de rotation de l'actionneur (441) ; et
un engrenage à crémaillère (443) disposé dans le deuxième boîtier (220) et comprenant une pluralité de dents en prise avec le pignon (442).

12. Dispositif électronique de la revendication 11, dans lequel la deuxième carte de circuit imprimé flexible (520) est configurée pour transmettre l'alimentation fournie par la batterie à travers la première carte de circuit(431) à la deuxième carte de circuit imprimé (432).

13. Dispositif électronique (200) de la revendication 11 ou de la revendication 12, dans lequel la deuxième carte de circuit imprimé flexible (520) est configurée pour transmettre un signal de commande provenant d'au moins un processeur disposé sur la deuxième carte de circuit imprimé (432) à l'actionneur (441).

14. Dispositif électronique de l'une des revendications 1 à 13, dans lequel la deuxième carte de circuit imprimé flexible (520) comprend une ligne de signal et une couche conductrice distincte de la ligne de signal.

15. Dispositif électronique (200) de l'une quelconque des revendications 1 à 14, dans lequel des vias conducteurs sont formés dans au moins un de ce qui suit :
la première région rigide (500A) de la première carte de circuit imprimé flexible (510) ;
la deuxième région rigide (500B) de la première carte de circuit imprimé flexible (510) ;
la troisième région rigide (500A) de la deuxième carte de circuit imprimé flexible (520) ; ou
la quatrième région rigide (500B) de la deuxième carte de circuit imprimé flexible (520),
dans lequel la région flexible (500C) est déformée pour correspondre à une rainure formée dans le premier boîtier (210) ou le deuxième boîtier (220).
